# EUROPÄISCHE PATENTSCHRIFT

(11) **EP 2 545 289 B1**
(45) Veröffentlichungstag und Bekanntmachung des Hinweises auf die Patenterteilung: **10.05.2017**
(21) Anmeldenummer: 11707819.6
(22) Anmeldetag: 03.03.2011
(51) Int. Cl.: F16B 33/00, F16B 43/00

(54) **STEUERGERÄT UND VERBINDUNGSEINRICHTUNG**
ELECTRONIC CONTROLLER AND CONNECTION DEVICE
UNITÉ DE COMMANDE ÉLECTRONIQUE ET DISPOSITIF DE LIAISON

(30) Priorität: 10.03.2010 DE 102010010926
(43) Veröffentlichungstag der Anmeldung: 16.01.2013
(73) Patentinhaber: KNORR-BREMSE Systeme für Nutzfahrzeuge GmbH, 80809 München (DE)
(72) Erfinder: EICHNER, Markus, 90408 Nürnberg (DE); UHLAND, Thomas, 74397 Pfaffenhofen (DE)
(74) Vertreter: Mattusch, Gundula
(86) Internationale Anmeldenummer: PCT/EP2011/053143
(87) Internationale Veröffentlichungsnummer: WO 2011/110461

(56) Entgegenhaltungen:
- EP-A1- 1 936 124
- FR-A1- 2 660 974
- GB-A- 747 922

## Beschreibung

Die vorliegende Erfindung betrifft ein Steuergerät mit einer an einem Träger angeordneten elektronischen Komponente, die vermittels einer Verbindungseinrichtung mit einem Gehäuseteil verbunden ist.
Einer der beschränkenden Faktoren bei der Verwendung elektronischer Komponenten und Steuergeräten in Hochtemperaturanwendungen, beispielsweise im Bereich von Kraft- und Nutzfahrzeugen und deren Steuerung, liegt in der Temperatur der verwendeten elektronischen Komponenten. Die elektronischen Komponenten funktionieren bei niedrigen Temperaturen besonders effizient und werden durch langen Betrieb bei hohen Temperaturen in Mitleidenschaft gezogen, so dass sich ihre Lebensdauer verringert. Daher werden insbesondere für einen Hochtemperaturbetrieb vorgesehene elektronische Komponenten häufig gekühlt und möglichst von externen Wärmequellen wie zum Beispiel einem Motor, einem Kompressor oder einem Getriebe eines Fahrzeugs thermisch entkoppelt. Dazu werden thermisch isolierende Verbindungseinrichtungen verwendet, um eine elektronische Komponente einerseits beispielsweise mit einem metallischen Gehäuse oder Gehäuseteil zu verbinden und andererseits davon thermisch zu isolieren. Zur stabilen Verbindung von Gehäuse und elektronischer Komponente werden in der Regel Buchsen und Schrauben verwendet, welche eine mechanische Verbindung durch eine thermische Isolierung hindurch erzeugen,

Aus der GB 747 922 A ist eine thermisch isolierende Verbindungseinrichtung im Zusammenhang mit einer Kälte- bzw. Kühlkammer bekannt.

Es ist eine Aufgabe der Erfindung, die thermische Isolierung zwischen einer elektronischen Komponente und einem Gehäuseteil, an dem die elektronische Komponente befestigt ist, zu verbessern.

Diese Aufgabe wird durch die Merkmale des unabhängigen Anspruchs gelöst. Weitere vorteilhafte Ausgestaltungen und Weiterbildungen der Erfindung ergeben sich aus den abhängigen Ansprüchen.
Die Erfindung stellt eine Verbindungseinrichtung zum Verbinden einer an einem Träger angeordneten elektronischen Komponente mit einem Gehäuseteil bereit. Die Verbindungseinrichtung umfasst eine erste Buchse zur Aufnahme einer ersten Befestigungsvorrichtung zum Befestigen der Verbindungseinrichtung an dem Träger und eine zweite Buchse zur Aufnahme einer zweiten Befestigungsvorrichtung zum Befestigen der Verbindungseinrichtung an dem Gehäuseteil. Die erste Buchse ist thermisch von der zweiten Buchse isoliert. Damit wird verhindert, dass über eine Buchse beziehungsweise eine Befestigungsvorrichtung eine thermisch leitende Verbindung zwischen der elektronischen Komponente und dem Gehäuseteil besteht. Dabei sollte jede der Befestigungsvorrichtungen derart ausgebildet sein, dass sie jeweils nur zum Befestigen der Verbindungseinrichtung an einem weiteren Bauteil dient, also entweder dem Träger oder dem Gehäuseteil. Es ergibt sich somit eine wechselseitige Befestigung von Träger, Verbindungseinrichtung und Gehäuseteil. Als Befestigungsvorrichtungen kommen insbesondere Bolzen, Schrauben oder Nieten in Frage. Die Befestigungsvorrichtungen sind aus Stabilitätsgründen zweckmäßigerweise aus einem metallischen Material wie Stahl oder Messing hergestellt. Es kann insbesondere vorgesehen sein, dass für die erste und die zweite Befestigungsvorrichtung unterschiedliche Arten von Befestigungsvorrichtungen und/oder unterschiedliche Materialien verwendet werden. Beispielsweise kann die erste Befestigungsvorrichtung eine Schraube sein und die zweite Befestigungsvorrichtung eine Niete oder umgekehrt. Die Buchsen sollten jeweils auf die Art der ihnen zugeordneten Befestigungsvorrichtung angepasst sein. Sollte als Befestigungsvorrichtung für eine Buchse beispielsweise eine Schraube Verwendung finden, kann die Buchse als Gewindebuchse ausgelegt sein. Die Buchsen können als durchgehende Buchsen mit zwei gegenüberliegenden Öffnungen oder als Buchsen mit nur einer Öffnung ausgebildet sein. Es ist vorteilhaft, wenn zumindest eine der Buchsen keine durchgehende Buchse mit zwei gegenüberliegenden Öffnungen ist, sondern an einem Ende in einem Buchsenendbereich abgeschlossen ist. Auch können Gehäuseteil und/oder Träger Gegenbefestigungseinrichtungen zum Befestigen der Befestigungsvorrichtungen aufweisen. Beispielsweise ist es vorstellbar, dass Gehäuseteil und/oder Träger eine Aufnahme für eine zugeordnete Befestigungsvorrichtung aufweisen. Eine solche Aufnahme kann als eine durchgehende Öffnung wie eine Durchgangsbohrung ausgebildet sein, oder als eine nur einseitig offene Vertiefung. Besonders vorteilhaft ist es, wenn jeweils eine Buchse und eine zugeordnete Gegenbefestigungseinrichtung derart ausgebildet sind, dass jeweils eines dieser beiden Elemente mit einer durchgehenden Aufnahme beziehungsweise Bohrung für die zugeordnete Befestigungsvorrichtung ausgebildet ist. Das andere dieser Elemente verfügt dann über eine Vertiefung mit nur einer Öffnung. Ferner kann eine Aufnahme mit einem Gewinde versehen sein. In der Regel ist es vorteilhaft, wenn eine Aufnahme als Durchgangsloch ausgebildet ist, und die andere Aufnahme als einseitig abgeschlossene Vertiefung. Beispielsweise kann vorgesehen sein, dass im Gehäuseteil zur Aufnahme der zweiten Befestigungsvorrichtung ein durchgehendes Loch vorgesehen ist, während der Träger eine geschlossene Vertiefung zur Aufnahme der ersten Befestigungsvorrichtung aufweist. Die jeweilige Befestigungsvorrichtung kann dann derart in die zugeordnete Buchse und Gegenbefestigungseinrichtung aufgenommen sein, dass eines ihrer Enden in einer an einem Ende abgeschlossenen Vertiefung aufgenommen ist. Somit ist dieses Ende der Befestigungsvorrichtung gegen Einwirkungen von außen geschützt und kann auch keine anderen Komponenten oder gar einen Benutzer gefährden. Es ist vorstellbar, dass eine durchgehende ausgebildete Aufnahme oder Buchse ohne Gewinde ausgebildet ist, während eine zugeordnete einseitig abgeschlossene Vertiefung über ein Gewinde verfügt. Als zugehörige Befestigungsvorrichtungen sind dann beispielsweise Bolzen geeignet, die nur am zur Aufnahme in der Vertiefung vorgesehenen Ende über ein entsprechendes Gegengewinde verfügen. Selbstverständlich ist es vorstellbar, dass die Verbindungseinrichtung mehr als zwei voneinander thermisch isolierte Buchsen zur Aufnahme einer Befestigungsvorrichtung zum Befestigen der Verbindungsvorrichtung an dem Gehäuseteil oder dem Träger aufweist, um die Stabilität der Verbindung zur erhöhen. Es kann auch vorgesehen sein, dass die Verbindungseinrichtung mehr als zwei Buchsen aufweist, um eine oder mehrere elektronische Komponenten beziehungsweise ihre Träger mit einem oder mehreren Gehäuseteilen zu verbinden. Der Träger dient zur Befestigung der elektronischen Komponente an der Verbindungseinrichtung und soll der Befestigungsvorrichtung Halt geben. Er kann einstückig mit der elektronischen Komponente ausgebildet sein und beispielsweise ein Substrat einer Leiterplatte sein. Es ist zweckmäßig, dass dann, wenn der Träger und die elektronische Komponente nicht einstückig ausgebildet sind, die elektronische Komponente auf bekannte Art an dem Träger befestigt ist, beispielsweise durch Verlöten oder Verschrauben. Die elektronische Komponente kann beispielsweise eine Leiterplatte, ein integrierter Schaltkreis, ein Prozessor, ein Sensor oder ein anderes geeignetes elektronisches Bauteil sein. Die elektronische Komponente kann auch mehrere derartiger Bauteile umfassen. Der Gehäuseteil kann beispielsweise ein Teil eines Gehäuses eines Steuergeräts sein. Es ist auch vorstellbar, dass der Gehäuseteil Teil eines Gehäuses einer Fahrzeugkomponente wie eines Motors, eines Antriebsstrangs, eines Kompressors oder eines Getriebes ist. Vorzugsweise ist der Gehäuseteil aus einem metallischen Material hergestellt, etwa in einem Aluminiumdruckgussverfahren. Er kann beispielsweise an einer Fahrzeugkomponente wie einem Getriebe angeflanscht sein. Die beschriebene Verbindungseinrichtung eignet sich besonders zum Einsatz im Bereich von Nutzfahrzeugen wie beispielsweise Lastkraftwagen und Traktoren. Erfindungsgemäß weist die Verbindungseinrichtung einen Rahmen auf, in welchem die Buchsen aufgenommen sind. Dadurch ergibt sich ein guter Halt für die Buchsen. Der Rahmen ist als ein die elektronische Komponente ganz oder teilweise umlaufender Rahmen ausgebildet. Insbesondere kann die elektronische Komponente in einer Ebene vollständig durch den Rahmen umgeben sein. Dabei ist es besonders vorteilhaft, wenn der Rahmen mehr als zwei Buchsen aufweist. Insbesondere können jeweils mehr als eine Buchse zur Aufnahme von Befestigungsvorrichtungen zum Befestigen des Rahmens an dem Träger und mehr als eine Buchse zur Aufnahme von Befestigungsvorrichtungen zum Befestigen des Rahmens an dem Gehäuseteil vorgesehen sein. Somit ergibt sich eine zuverlässige Befestigung von Träger, Verbindungsvorrichtung beziehungsweise Rahmen und Gehäuseteil. Es können auch mehrere separat ausgebildete Verbindungseinrichtungen vorgesehen sein.

Der Rahmen kann aus einem Kunststoff hergestellt sein. Insbesondere kann der Kunststoff ein wärmeisolierender Kunststoff sein. Dies ermöglicht eine einfache Herstellung beispielsweise durch ein Gussverfahren und sorgt für eine Isolierung der Buchsen. Insbesondere können die Buchsen mit dem Kunststoff umspritzt werden, um eine leicht herzustellende Verbindungseinrichtung zu ergeben. Besonders geeignet als Rahmenmaterial ist Polyamid mit Glasfasern, das gewünschte Eigenschaften hinsichtlich Stabilität und Wärmeisolierung mit sich bringt.

Bei einer bevorzugten Ausführungsform sind die erste Buchse und die zweite Buchse mit einer gemeinsamen Aufnahmerichtung zur Aufnahme der ersten Befestigungsvorrichtung beziehungsweise der zweiten Befestigungsvorrichtung ausgebildet. Die erste und die zweite Befestigungsvorrichtung werden also beim Montieren von der gleichen Seite der Verbindungseinrichtung parallel in die Buchsen eingeführt und sind im montierten Zustand parallel zueinander in den Buchsen aufgenommen. Dadurch ergibt sich einerseits eine leichte Montage. Andererseits muss nur auf einer Seite der elektronischen Komponente für ausreichend Platz zum Einführen und zur Aufnahme der Befestigungsvorrichtungen gesorgt werden. Es ist selbstverständlich auch möglich, die Buchsen derart auszubilden, dass sie in unterschiedliche Richtungen ausgebildet sind und somit die Befestigungsvorrichtungen in entsprechenden unterschiedlichen Aufnahmerichtungen in die Buchsen eingeführt werden. Dabei kann es besonders vorteilhaft sein, wenn die Aufnahmerichtungen der Buchsen einander entgegengesetzt ausgerichtet sind. Bei der Festlegung einer Aufnahmerichtung sind gegebenenfalls das Vorhandensein und die Ausrichtung von Gewinden und die Ausgestaltung von Buchsen und Gegenbefestigungseinrichtungen mit Durchgangslöchern oder nur einseitig offenen Vertiefungen zu berücksichtigen.

Es ist besonders vorteilhaft, wenn die erste und die zweite Buchse gegeneinander versetzt angeordnet sind. Dies erleichtert den Zusammenbau und verhindert, dass Teile der Befestigungsvorrichtungen in einem Außenbereich über eine dort angeordnete weitere wärmeleitende Komponente miteinander in wärmeübertragenden Kontakt gelangen.

Gemäß einer Weiterbildung sind die erste und die zweite Buchse bezüglich einer gemeinsamen Aufnahmerichtung zur Aufnahme der ersten Befestigungsvorrichtung beziehungsweise der zweiten Befestigungsvorrichtung gegeneinander versetzt angeordnet. Dies wirkt einem Effekt entgegen, dass auf einer Seite (beispielsweise der Seite, von der die Befestigungsvorrichtungen bei der Montage in die Buchsen eingeführt werden) herausstehende Enden der Befestigungsvorrichtungen wie beispielsweise Schrauben- oder Bolzenköpfe gleichzeitig in wärmeleitenden Kontakt mit einer heißen Komponente gelangen und so eine wärmeleitende Verbindung herstellen.

Es ist besonders vorteilhaft, wenn die elektronische Komponente einen elektronischen Schaltungsträger, inbesondere eine Leiterplatte, umfasst. Auf einer solchen Leiterplatte lassen sich auf einfache Art komplexe Schaltungen unterbringen und montieren. Ein Substrat der Leiterplatte kann als Träger dienen. Allerdings ist es auch möglich, einen zusätzlichen Träger einzusetzen.

Vorzugsweise ist ein Kühler zum Kühlen der elektronischen Komponente vorgesehen. Insbesondere in Hochtemperaturumgebungen kann so die elektronische Komponente auf einer niedrigen Betriebstemperatur gehalten werden, was ihre Leistungsfähigkeit und Lebensdauer erhöht. Der Kühler kann aus einem Material mit guten wärmeleitenden Eigenschaften ausgebildet sein. Besonders geeignet ist die Herstellung in einem Aluminiumdruckgussverfahren, das sich preisgünstig durchführen lässt und einen Kühler mit niedrigem Gewicht erzeugen lässt. Der Kühler kann mit einem Kühlsystem verbunden sein, das somit den Kühler kühlt. Beispielsweise kann vorgesehen sein, dass ein Kühlmittelstrom zum Kühlen des Kühlers eingesetzt ist. Bei dem Kühlsystem kann es sich um ein Kühlsystem eines Kraftfahrzeugs handeln. In diesem Zusammenhang ist es zweckmäßig, wenn der Kühler der Träger ist, an dem die elektronische Komponente angeordnet ist. Ein derartiger Kühler besitzt eine ausreichende Stabilität, um eine gute mechanische Verbindung über eine Befestigungsvorrichtung zu bieten. Die Verbindungseinrichtung kann mindestens eine Dichtungseinrichtung zum Abdichten eines zwischen dem Gehäuseteil und dem Träger gebildeten Zwischenraums gegen eine Umgebung der Verbindungseinrichtung aufweisen. Die Umgebung der Verbindungseinrichtung ist dabei vorzugsweise ein Bereich, der durch die Verbindungseinrichtung von der elektronischen Komponente beziehungsweise dem Zwischenraum getrennt ist. Der Zwischenraum bietet Platz zur Aufnahme der elektronischen Komponente und weiterer eventuell vorgesehener Komponenten, wie beispielsweise elektrischer Leitungen. Vorzugsweise ist der Zwischenraum derart dimensioniert, dass sich zwischen einer in ihm aufgenommenen elektronischen Komponenten und dem Gehäuseteil ein Abstand ergibt. Somit wird verhindert, dass die elektronische Komponente in direktem Kontakt mit dem Gehäuseteil steht. Durch die Dichtungseinrichtung sind der Zwischenraum und damit auch die elektronische Komponente beispielsweise gegen von außen eindringende Feuchtigkeit geschützt. Erfindungsgemäß ist ferner ein Steuergerät mit einer an einem Träger angeordneten elektronischen Komponente vorgesehen, die vermittels der oben beschriebenen Verbindungseinrichtung mit einem Gehäuseteil verbunden ist.

Dadurch ergibt sich eine gute thermische Isolierung der Steuereinrichtung beziehungsweise der elektronischen Komponente von dem Gehäuseteil. Dabei kann der Gehäuseteil ein Teil eines Gehäuses des Steuergeräts sein. Es ist auch vorstellbar, dass der Gehäuseteil Teil eines Gehäuses einer von dem Steuergerät unterschiedlichen Komponente ist, bei der es sich um ein Bauteil wie oben beschrieben handeln kann. Es ist auch eine Kombination aus beidem vorstellbar. So kann einerseits eine elektronische Komponente über eine beschriebene Verbindungseinrichtung mit einem Teil eines Gehäuses des Steuergeräts verbunden sein, und andererseits dieser oder ein anderer Teil des Gehäuses des Steuergeräts über eine solche Verbindungseinrichtung mit einem Gehäuseteil einer weiteren Komponente verbunden sein. In diesem Fall kann eine einzelne Verbindungseinrichtung vorgesehen sein, die mit mehr als zwei Buchsen versehen ist, um die elektronische Komponente und die Gehäuseteile miteinander zu verbinden. Es können auch mehrere Verbindungseinrichtungen eingesetzt sein.

Die Erfindung wird nun mit Bezug auf die begleitende Zeichnung anhand einer bevorzugten Ausführungsform beispielhaft erläutert.

Es zeigt:

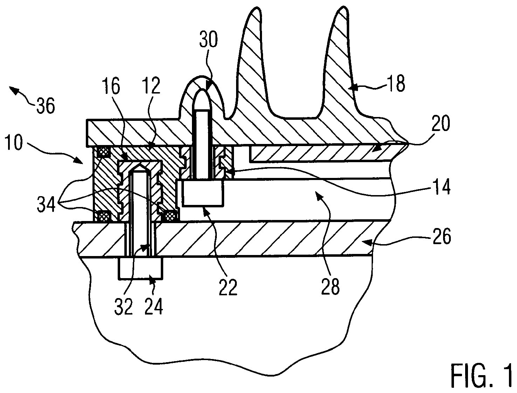

- Figur 1: Eine Ansicht einer Verbindungsvorrichtung.

Figur 1 zeigt eine Verbindungseinrichtung 10. Die Verbindungseinrichtung 10 umfasst einen aus Kunststoff hergestellten Rahmen 12. Der Rahmen 12 weist eine erste Buchse 14 und eine zweite Buchse 16 auf. Es kann vorgesehen sein, dass der Rahmen 12 in einem Spritzgussverfahren hergestellt ist, bei dem die Buchsen 14 und 16 mit Rahmenmaterial umspritzt werden. Aus Stabilitätsgründen sind die Buchsen 14 und 16 aus einem metallischen Material hergestellt. Wie zu erkennen ist, weisen die Buchsen 14, 16 Hinterschneidungen auf, um einen guten Halt in dem Rahmen 12 zu erreichen. Es ist auch vorstellbar, eine oder beide Buchsen 14, 16 aus einem anderen Material herzustellen oder direkt den Rahmen 12 derart zu formen, dass sich den Buchsen entsprechende Formen zur Aufnahme von Befestigungsvorrichtungen ergeben. Die erste Buchse 14 ist derart ausgebildet, dass sie eine durch den Rahmen 12 durchgehende Öffnung bietet. Die zweite Buchse 16 hingegen ist an einem innerhalb des Rahmens 12 gelegenen Ende geschlossen. Beide Buchsen 14, 16 können ein Gewinde aufweisen. Figur 1 zeigt ferner einen Kühler 18 sowie einen Teil eines Gehäuses 26. Der Gehäuseteil 26 ist in diesem Fall durch ein Aluminiumdruckgussverfahren hergestellt. Insbesondere kann der Gehäuseteil 26 Teil eines Gehäuses eines Fahrzeuggetriebes sein. Die Verbindungseinrichtung 10 ist derart zwischen dem Kühler 18 und dem Gehäuse 26 angeordnet, dass sich zwischen dem Kühler 18 und dem Gehäuseteil 26 ein Zwischenraum 28 ergibt. In diesem Zwischenraum 28 ist eine elektronische Komponente 20 aufgenommen, in diesem Fall eine Leiterplatte 20. Eine Umgebung 36 der Verbindungseinrichtung 10 ist durch die Verbindungseinrichtung 10 von dem Zwischenraum 28 getrennt. Die Leiterplatte 20 ist wärmeleitend an dem Kühler 18 befestigt, beispielsweise über eine Wärmeleitpaste. Zur Befestigung der Leiterplatte 20 können vorzugsweise Schrauben oder eine Verklebung vorgesehen sein (nicht gezeigt). Der Kühler 18 dient dazu, im Betrieb der Leiterplatte 20 produzierte Wärme von dieser abzuführen. Er kann beispielsweise mit einer Kühlvorrichtung eines Fahrzeugs verbunden sein, um selbst gekühlt zu werden. In die erste Buchse 14 ist eine erste Befestigungsvorrichtung 22 aufgenommen, welche durch die erste Buchse 14 hindurchgeht und in einer im Kühler 18 als Vertiefung 30 ausgebildeten Gegenbefestigungsvorrichtung aufgenommen ist. Die Vertiefung 30 kann ein Gewinde aufweisen. Somit ist die Verbindungseinrichtung 10 mit dem Kühler 18 verbunden, der in diesem Beispiel als Träger der elektronischen Komponente beziehungsweise Leiterplatte 20 wirkt. Ferner ist in dem Gehäuseteil 26 ein Befestigungsoder Durchgangsloch 32 vorgesehen, das ein Gewinde aufweisen kann. Eine zweite Befestigungsvorrichtung 24 erstreckt sich durch das Durchgangsloch 32 hindurch und in die zweite Buchse 16 hinein. Dadurch sind die Verbindungseinrichtung 10 und das Gehäuse 26 miteinander verbunden. Zur Abdichtung des Gehäuseteils 26, des Rahmens 12 und des Kühlers 18 gegeneinander und insbesondere zur Abdichtung des Zwischenraums 28 gegen die Umgebung 36 sind Dichtungen 34 vorgesehen. Es können dabei jeweils auf der dem Träger zugewandten Seite des Rahmens 12 und auf der dem Gehäuseteil 26 zugewandten Seite des Rahmens 12 eine oder mehrere Dichtungen 34 vorgesehen sein. Die erste und/oder die zweite Befestigungsvorrichtung 22, 24 können ein Gewinde aufweisen beziehungsweise als Schrauben ausgebildet sein. Die Buchsen 14, 16 weisen eine gemeinsame Aufnahmerichtung für die ihnen zugeordneten Befestigungsvorrichtungen 22, 24 auf. Das heißt, beide Befestigungsvorrichtungen 22, 24 werden aus der gleichen Richtung in ihre zugehörige Buchse 14, 16 eingeführt. Dies geschieht in diesem Fall derart, dass sie in der Richtung auf den Kühler 18 zu eingeführt werden. Bei der Montage wird zuerst die Verbindungseinrichtung 10 über die erste Befestigungsvorrichtung 22 fest mit dem Kühler 18 verbunden. Dann wird durch Einführen der zweiten Befestigungsvorrichtung 24 in das Durchgangsloch 32 und in die zweite Buchse 16 der Gehäuseteil 26 mit der Verbindungseinrichtung 10 verbunden. Insgesamt ergibt sich eine stabile Befestigung des Kühlers 18 und der Leiterplatte 20 an dem Gehäuseteil 26, ohne dass über eine der Buchsen 14, 16 oder eine der Befestigungsvorrichtungen 22, 24 eine wärmeleitende Verbindung zwischen Gehäuseteil 26 und Kühler 18 besteht. Wie gut zu erkennen ist, ergibt sich zwischen dem Gehäuseteil 26 und der ersten Befestigungsvorrichtung 22 ein Freiraum, so dass Gehäuseteil 26 und erste Befestigungsvorrichtung 22 nicht in wärmeleitenden Kontakt stehen, da der Rahmen 12 aus wärmeisolierendem Material hergestellt ist. Auch sind die erste Buchse 14 und die zweite Buchse 16 durch das wärmeisolierende Material des Rahmens 12 voneinander getrennt und befinden sich nicht in wärmeleitendem Kontakt miteinander. Zwar sind die zweite Buchse 16 und die Befestigungsvorrichtung 24 wärmeleitend mit dem Gehäuseteil 26 verbunden. Durch die Umhüllung der zweiten Buchse 16 durch das Rahmenmaterial 12 sind sie jedoch sowohl von der Befestigungsvorrichtung 22 und der Buchse 14 als auch dem Kühler 18 thermisch isoliert. Es kann selbstverständlich vorgesehen sein, dass zur Verbindung des Kühlers 18 mit dem Gehäuseteil 26 mehr als eine Verbindungsvorrichtung 10 verwendet wird. Besonders zweckmäßig ist es, wenn die Leiterplatte 20 zwischen zumindest zwei Verbindungseinrichtungen 10 angeordnet und vermittels dieser an dem Gehäuseteil 26 befestigt ist. Alternativ kann der Rahmen 12 beispielsweise derart ausgebildet sein, dass er die Leiterplatte 20 ganz umläuft und eine Vielzahl von über den Rahmen 12 verteilten Buchsen 14, 16 aufweist. Es ist dann zweckmäßig, an dem Rahmen 12 mindestens eine ebenfalls umlaufende Dichtung 34 vorzusehen.

### Bezugszeichenliste

- 10: Verbindungseinrichtung
- 12: Rahmen
- 14: erste Buchse
- 16: zweite Buchse
- 18: Kühler
- 20: Leiterplatte
- 22: erste Befestigungsvorrichtung
- 24: zweite Befestigungsvorrichtung
- 26: Gehäuseteil
- 28: Zwischenraum
- 30: Vertiefung
- 32: Durchgangsloch
- 34: Dichtung
- 36: Umgebung

## Patentansprüche

1. Steuergerät mit einer an einem Träger (18) angeordneten elektronischen Komponente (20), die vermittels einer Verbindungseinrichtung (10) mit einem Gehäuseteil (26) verbunden ist, wobei die Verbindungseinrichtung (10) umfasst:
- eine erste Buchse (14) zur Aufnahme einer ersten Befestigungsvorrichtung (22) zum Befestigen der Verbindungseinrichtung (10) an dem Träger (18);
- eine zweite Buchse (16) zur Aufnahme einer zweiten Befestigungsvorrichtung (24) zum Befestigen der Verbindungseinrichtung (10) an dem Gehäuseteil (26), wobei die erste Buchse (14) thermisch von der zweiten Buchse (16) isoliert ist; und
- einen Rahmen (12), in welchen die Buchsen (14, 16) aufgenommen sind, wobei der Rahmen (12) als die elektronische Komponente (20) ganz oder teilweise umlaufender Rahmen ausgebildet ist.

2. Steuergerät nach Anspruch 1, wobei der Rahmen (12) aus einem Kunststoff hergestellt ist.

3. Steuergerät nach Anspruche 1 oder 2, wobei die erste Buchse (14) und die zweite Buchse (16) mit einer gemeinsamen Aufnahmerichtung zur Aufnahme der ersten Befestigungsvorrichtung (22) beziehungsweise der zweiten Befestigungseinrichtung (24) ausgebildet sind.

4. Steuergerät nach einem der Ansprüche 1 bis 3, wobei die erste Buchse (14) und die zweite Buchse (16) gegeneinander versetzt angeordnet sind.

5. Steuergerät nach einem der vorhergehenden Ansprüche, wobei die erste und die zweite Buchse (14, 16) bezüglich einer gemeinsamen Aufnahmerichtung zur Aufnahme der ersten Befestigungsvorrichtung (22) beziehungsweise der zweiten Befestigungsvorrichtung (24) gegeneinander versetzt angeordnet sind.

6. Steuergerät nach einem der vorhergehenden Ansprüche, wobei die elektronische Komponente (20) einen elektronischen Schaltungsträger, insbesondere eine Leiterplatte, umfasst.

7. Steuergerät nach einem der vorhergehenden Ansprüche, wobei ein Kühler zum Kühlen der elektronischen Komponente (20) vorgesehen ist.

8. Steuergerät nach Anspruch 7, wobei der Kühler der Träger (18) ist.

9. Steuergerät nach einem der vorhergehenden Ansprüche, wobei die Verbindungseinrichtung (10) mindestens eine Dichtungseinrichtung (34) zum Abdichten eines zwischen dem Gehäuseteil (26) und dem Träger (18) gebildeten Zwischenraums (28) gegen eine Umgebung (36) der Verbindungseinrichtung (10) aufweist.

## Claims

1. Control unit comprising an electronic component (20) located on a support (18) and connected to a housing part (26) by means of a connecting device (10), the connecting device (10) comprising:
- a first bushing (14) for the reception of a first fastening device (22) for fastening the connecting device (10) on the support (18);
- a second bushing (16) for the reception of a second fastening device (22) for fastening the connecting device (10) on the housing part (26), the first bushing (14) being thermally insulated against the second bushing (16); and
- a frame (12), in which the bushings (14, 16) are accommodated, the frame (20) being designed as a frame which completely or partially surrounds the electronic component (20).

2. Control unit according to claim 1, wherein the frame (20) is made of a plastic material.

3. Control unit according to claim 1 or 2, wherein the first bushing (14) and the second bushing (16) are designed with a common reception direction for the reception of the first fastening device (22) and the second fastening device (22) respectively.

4. Control unit according to any of claims 1 to 3, wherein the first bushing (14) and the second bushing (16) are arranged with an offset against each other.

5. Control unit according to any of the preceding claims, wherein the first and the second bushings (14, 16) are arranged with an offset against each other in respect of a common reception direction for the reception of the first fastening device (22) and the second fastening device (22) respectively.

6. Control unit according to any of the preceding claims, wherein the electronic component (20) comprises an electronic circuit carrier, in particular a printed circuit board.

7. Control unit according to any of the preceding claims, wherein a cooler is provided for cooling the electronic component (20).

8. Control unit according to claim 7, wherein the cooler is the support (18).

9. Control unit according to any of the preceding claims, wherein the connecting device (10) comprises at least one sealing device (34) for sealing a space (28) formed between the housing part (26) and the support (18) against surroundings (36) of the connecting device (10).

## Revendications

1. Appareil de commande comprenant un composant (20) électronique, qui est monté sur un support (18) et qui est relié à une partie (26) de boîtier au moyen d'un dispositif (10) de liaison, le dispositif (10) de liaison comprenant :
- une première douille (14) de réception d'un premier dispositif (22) de fixation pour fixer le dispositif (10) de liaison au support (18) ;
- une deuxième douille (16) de réception d'un deuxième dispositif (24) de fixation pour fixer le dispositif (10) de liaison à la partie (26) de boîtier, la première douille (14) étant isolée thermiquement de la deuxième douille (16) et
- un cadre (12), dans lequel les douilles (14, 16) sont reçues, le cadre (12) étant constitué sous la forme d'un cadre entourant, en tout ou partie, le composant (20) électronique.

2. Appareil de commande suivant la revendication 1, dans lequel le cadre (12) est en matière plastique.

3. Appareil de commande suivant la revendication 1 ou 2, dans lequel la première douille (14) et la deuxième douille (16) sont constituées en ayant un dispositif de réception commun pour la réception du premier dispositif (22) de fixation et respectivement du deuxième dispositif (24) de fixation.

4. Appareil de commande suivant l'une des revendications 1 à 3, dans lequel la première douille (14) et la deuxième douille (16) sont décalées l'une par rapport à l'autre.

5. Appareil de commande suivant l'une des revendications précédentes, dans lequel la première et la deuxième douilles (14, 16) sont décalées l'une par rapport à l'autre par rapport à un dispositif de réception commun de réception du premier dispositif (22) de fixation et respectivement du deuxième dispositif (24) de fixation.

6. Appareil de commande suivant l'une des revendications précédentes, dans lequel le composant (20) électronique comprend un support de circuit électronique, notamment une plaquette à circuit imprimé.

7. Appareil de commande suivant l'une des revendications précédentes, dans lequel un dissipateur de chaleur est prévu pour refroidir le composant (20) électronique.

8. Appareil de commande suivant la revendication 7, dans lequel dissipateur de chaleur est le support (18).

9. Appareil de commande suivant l'une des revendications précédentes, dans lequel le dispositif de liaison a au moins un dispositif (34) d'étanchéité pour rendre étanche, vis-à-vis de l'environnement (36) du dispositif (10) de liaison, un espace (28) intermédiaire formé entre la partie (26) de boîtier et le support (18).
